(19) **Europäisches Patentamt / European Patent Office / Office européen des brevets**

(11) **EP 1 947 923 A1**

(12) **EUROPEAN PATENT APPLICATION**
published in accordance with Art. 158(3) EPC

(43) Date of publication:
**23.07.2008 Bulletin 2008/30**

(21) Application number: **06821927.8**

(22) Date of filing: **18.10.2006**

(51) Int Cl.:
*H05K 9/00* (2006.01)  *C01B 31/02* (2006.01)
*D01F 9/127* (2006.01)  *H01Q 17/00* (2006.01)

(86) International application number:
**PCT/JP2006/320733**

(87) International publication number:
**WO 2007/046412 (26.04.2007 Gazette 2007/17)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **19.10.2005 JP 2005305072**

(71) Applicants:
• **Bussan Nanotech Research Institute Inc.**
  **Tokyo 100-0004 (JP)**
• **MITSUI & CO., LTD.**
  **Tokyo 100-0004 (JP)**

(72) Inventors:
• **UMISHITA, Kazunori**
  **Tokyo 100-0004 (JP)**
• **OKUBO, Tsuyoshi**
  **Tokyo 100-0004 (JP)**

(74) Representative: **Brykman, Georges et al**
**Osha Liang**
**121, Avenue des Champs Élysées**
**F-75008 Paris (FR)**

(54) **ELECTROMAGNETIC WAVE ABSORBER**

(57)     By using a high electromagnetic wave absorbing loss material and adding it in a small amount to a matrix, an electromagnetic wave absorber useful for GHz band, which can demonstrate the electromagnetic wave absorption capability without ruining characteristics of the matrix, and can enjoy a good formability and a low manufacturing cost, is provided.

The disclosed is an electromagnetic wave absorber which is **characterized in that** carbon fibrous structures are contained in the matrix, at a rate of 0.01 - 25 % by weight based on the total weight, wherein the carbon fibrous structure comprises a three dimensional network of carbon fibers each having an outside diameter of 15 - 100 nm, wherein the carbon fibrous structure further comprises a granular part with which the carbon fibers are tied together in the state that the concerned carbon fibers are externally elongated therefrom, and wherein the granular part is produced in a growth process of the carbon fibers.

FIG. 4A

EP 1 947 923 A1

Description

TECHNICAL FIELD

This invention relates to an electromagnetic wave absorber, especially, to an electromagnetic wave absorber for gigahertz (GHz) band.

BACKGROUND ART

Recently, high-speed processing of electronic devices has been accelerated, and the operating frequencies for ICs such as LSIs or microprocessors have been ascended rapidly. Thus, there are increasing tendencies to emit unnecessary noises. In addition, in the field of communications, 2 GHz has been utilized for the next generation multimedia mobile communication, 2 - 30 GHz for wireless LAN, and high-speed communication network using optical fibers, as well as 5.8 GHz for ETS (Electronic Toll Collection System) and 76GHz for AHS (advanced cruise-assist highway system) in the field of ITS(Intelligent Transport System), etc. Further, the range of using the high frequency such as GHz band is expected to be going to expand rapidly in the future.

By the way, when the frequency of the electromagnetic waves rise, the misoperations of electronic devices due to EMI (Electro-Magnetic Interference) will arise because of the degression in the noise margin due to the energy - saving of the recent electronic devices, and the deterioration of the environment of the noise in the electronic devices due to the tendency of miniaturizing and densification of electronic devices, while the electromagnetic waves becomes easy to be radiated as noise. Thus, in order to decrease EMI in an electronic device, measures such as the arrangement of the electromagnetic wave absorber in the electronic device have been taken. Conventionally, as the electromagnetic wave absorber for GHz band, a seat-like article which is made by combining an electrical insulating organic material such as rubber or resin with a soft magnetic metallic material having spinel crystal structure and a loss material such as carbon material is mainly utilized.

However, the relative permeability of the soft magnetic metallic oxide material having spinel crystal structure decreases abruptly at the GHz band according to Snoek's law of threshold. Therefore, the threshold frequency of the material as the electromagnetic wave absorber is a few several GHz. With respect to the soft magnetic metallic material, although it is possible to extend the threshold frequency of the material as the electromagnetic wave absorber up to about 10 GHz owing to the repression effect against the eddy currents and the effect of magnetic shape anisotropy which are obtained by forming particles into flatten shapes of not more than the skin depth, however, such a magnetic material has a heavy weight, and thus, it is impossible to achieve a light weight electromagnetic wave absorber.

On the other hand, as the electromagnetic wave absorber for millimeter wave range, an electromagnetic wave absorber in which carbonaceous material such as carbon black particles or carbon fibers is dispersed in an electrical insulating organic material such as rubber or resin is known in the art. However, its electromagnetic wave absorption capability does not reach a sufficient level, and thus, the development of an electromagnetic wave absorber excellent in the electromagnetic wave absorption capability which can be used even for the millimeter wave range has been sought.

In addition, in the patent literature 1, an electromagnetic wave absorber which contains electro conductive carbon nanotubes has been disclosed, and it has been reported that the attenuation rates of -13 dB(5GHz, 0.105mm in thickness) and-23dB(5GHz, 0.105mm in thickness) were obtained. In the patent literature 2, carbon nanotube which bore or involved alkaline, alkaline earth metal, rare earth, or VIII group's metal has been disclosed, and it has been reported that the attenuation rates of -28 dB (16GHz, 1mm in thickness), -34dB (10GHz, 1.5mm in thickness), and -27dB (7GHz, 2mm in thickness) were obtained in a composite in which 20 parts by weight of Fe involved carbon nanotubes were contained in polyester or the like. In the patent literature 3, a polymer composite which contained 20 parts by weight of carbon nanotubes having a diameter of 1 - 100 nm and a length of not more than 50 $\mu$m has been disclosed, and it has been reported that the attenuation rates of -37 dB (9.5 GHz, 1mm in thickness), -27 dB (2.7 GHz, 0.8mm in thickness), and -30 dB (2.1GHz, 0.8mm in thickness) were obtained. In the patent literature 4, it has been reported that the attenuation rates of 20-29 dB were obtained by a stacked structure of fibrous carbon or nano carbon. In the patent literature 5, an electromagnetic wave absorber obtained by placing carbon material including fibrous carbon and nano carbon tubes between resin coated papers, and heating and pressurizing them has been disclosed, and it has been reported that it could absorb the electromagnetic wave of 60GHz by 20-35 dB when the thickness of its conductive layer was 9mm.

Since the electromagnetic wave absorber described in the patent literature 1 is prepared by admixing graphite and resin in nearly equal proportions, it can hardly sustain the mechanical characteristics, such as toughness, of the resin. Further, the graphite makes the surface roughness rough, and this fact will cause an increase in the exfoliation of surface layer and a decrease in surface conductivity.

The supporting technology disclosed in the patent literature 2 is extremely difficult, and the leaved material to be supported and the leaved carbon nanotubes mutually independently agglomerate, and which is followed by the deterioration of the electromagnetic wave absorption capability. Particularly, the metals are easy to be oxidized because of its minute particle shapes, and thereby the electromagnetic wave absorption capability is degraded. Although such dropping off and oxidation can be solved by involving the material to be supported into the carbon nanotubes, the yield of such involved form is extremely low.

Next, in the patent literature 3, the electromagnetic wave absorption capability was obtained by including a comparatively high density, i.e., 1 - 10 parts by weight of carbon nanotubes, and the physical properties of the matrix, especially mechanical properties are subject to change. Moreover, the attenuation rate is varied greatly depending upon the carbon nanotubes used.

The electromagnetic wave absorber described in the patent literature 4 requires a metallic thin film, such as Ag, Cu, Au or Pt, of about 10 nm in thickness between two layers of carbon nanotube containing layers, and thus the manufacturing process becomes complicated one and costly.

In addition, in the patent literature 5, the electromagnetic wave absorption capability is obtained by shaping a rather large amount of carbonaceous material thickly. Therefore, the formability of the electromagnetic wave absorber is not good, and the usage thereof will be restricted.

Patent literature 1: JP 2005-11878 A

Patent literature 2: JP 2003-124011 A

Patent literature 3: JP 2003-158395 A

Patent literature 4: JP 2005-63994 A

Patent literature 5: JP 2004-327727 A

## DISCLOSURE OF THE INVENTION

## PROBLEMS TO BE SOLVED BY THIS INVENTION

Therefore, in view of the above mentioned problems in the prior arts, the present invention aims to provide a new electromagnetic wave absorber useful for GHz band. The present invention also aims to provide an electromagnetic wave absorber which can demonstrate the electromagnetic wave absorption capability without ruining the characteristic of the matrix, and can enjoy a good formability and a low manufacturing cost by using a high electromagnetic wave absorbing loss material and adding it in a small amount.

## MEANS FOR SOLVING THE PROBLEMS

After our diligent studies, we, the inventors, have found that the above problems can be solved by using a composite material in which relatively small amount of carbon fibrous structures are added and dispersed in the matrix, wherein the carbon fibrous structure comprises a three dimensional network of carbon fibers, and the carbon fibrous structure further comprises a granular part with which the carbon fibers are tied together in the state that the concerned carbon fibers are externally elongated therefrom, and wherein the granular part is produced in a growth process of the carbon fibers. Thus, we have attained the present invention.

That is, the electromagnetic wave absorber of the present invention which solves the above mentioned problems is characterized in that the carbon fibrous structures are contained in the matrix, at a rate of 0.01 - 25 % by weight based on the total weight, wherein the carbon fibrous structure comprises a three dimensional network of carbon fibers each having an outside diameter of 15 - 100 nm, wherein the carbon fibrous structure further comprises a granular part with which the carbon fibers are tied together in the state that the concerned carbon fibers are externally elongated therefrom, and wherein the granular part is produced in a growth process of the carbon fibers.

In the present invention, it is preferable that the carbon fibrous structures have $I_D/I_G$ ratio determined by Raman spectroscopy of not more than 0.2.

The present invention also provides the above mentioned electromagnetic wave absorber of which matrix comprises an organic polymer.

Further, the present invention provides the above mentioned electromagnetic wave absorber of which matrix comprises inorganic material.

Still further, the present invention provides the above mentioned electromagnetic wave absorber wherein a filling agent selected from the group consisting of metallic particles, silica, calcium carbonate, magnesium carbonate, carbon blacks, carbon fibers, glass fibers, and blends of two or more of these materials is further added therein.

## EFFECT OF THE INVENTION

Since the carbon fibrous structures included into the electromagnetic wave absorber according to the present invention shows a high loss characteristic against the electromagnetic waves of GHz band, the composite which includes such carbon fibrous structures can demonstrate strong electromagnetic radiation absorption regardless of the kind of matrix used. Therefore, the composite can be preferably used as electromagnetic wave absorber for computers, telecommunications equipments, and the electromagnetic wave using device, etc.

## BRIEF DESCRIPTION OF THE DRAWINGS

[Fig. 1] is a scanning electron micrograph (SEM photo) of an intermediate for the carbon fibrous structure which is used for the electromagnetic wave absorber according to the present invention.

[Fig. 2] is a transmission electron micrograph (TEM photo) of an intermediate for the carbon fibrous structure which is used for the electromagnetic wave absorber according to the present invention.

[Fig. 3] is a scanning electron micrograph (SEM photo) of a carbon fibrous structure which is used for the electromagnetic wave absorber according to the present invention.

[Fig. 4A] and [Fig. 4B] are transmission electron micrographs (TEM) of carbon fibrous structures which are used for the electromagnetic wave absorber according to the present invention.

[Fig. 5] is a scanning electron micrograph (SEM photo) of a carbon fibrous structure which is used for the electromagnetic wave absorber according to the present invention.

[Fig. 6] is an X-ray diffraction chart of a carbon fibrous structure which is used for the electromagnetic wave absorber according to the present invention and an intermediate thereof.

[Fig. 7] is Raman spectra of a carbon fibrous structure which is used for the electromagnetic wave absorber according to the present invention and an intermediate thereof

[Fig. 8] is a schematic diagram which illustrates a generation furnace used for manufacturing the carbon fibrous structures in an example of the present invention.

## EXPLANATION OF NUMERALS

1    Generation furnace
2    Inlet nozzle
3    Collision member
4    Raw material mixture gas supply port
a    Inner diameter of inlet nozzle
b    Inner diameter of generation furnace
c    Inner diameter of Collision member
d    Distance from upper end of generation furnace to raw material mixture gas supply port
e    Distance from raw material mixture gas supply port to lower end of collision member
f    Distance from raw material mixture gas supply port to lower end of generation furnace

## BEST MODE FOR CARRYING OUT THE INVENTION

Now, the present invention will be described in detail with reference to some preferable embodiments.
The electromagnetic wave absorber according to this invention is characterized in that carbon fibrous structures each having a specific structure like a three dimensional network as mentioned later are contained in the matrix, at a rate of 0.01 - 25 % by weight based on the total weight.

First, the function of the electromagnetic wave absorber according to the present invention will be explained. In general, the electromagnetic wave absorbing property of the electromagnetic wave absorber is greatly influenced by the frequency of the electromagnetic wave to be targeted, the thickness of the electromagnetic wave absorber, the amount and kind of the loss material such as carbon fibers which are added to the electromagnetic wave absorber, etc. Thus, it is considered that it is preferable to determine the complex permittivity exactly with respect to the variation of these conditions, and to make the optimum design in accordance with the result of the determination. However, as a factor which makes the optimum design more difficult, dispersion condition of the loss material in the matrix is considered. For instance, it is well known that, even if the same amount of the same loss material is added into an insulated matrix, the characteristics of the obtained product may be changed greatly depending on the manufacturing method of the product. That is because the dispersion condition of the loss material in the matrix is varied, and this fact appears as difference in the responding property to the electromagnetic waves.

In the case of the monofilament carbon nanotubes conventionally known in the art, they show their aggregate state even just after their synthesis since they have strong cohesiveness. When such monofilament carbon nanotubes are added to the matrix such as resin, the monofilament carbon nanotubes would be poorly dispersed, and thus they can not be distributed uniformly. That is, they would be distributed as some aggregates. Therefore, uniform conductive paths in plane can not be formed, and thus there is a fear that the product obtained would bring a defective performance. Accordingly, given a desired property such as electric conductivity for a matrix such as resin, it is necessary that the monofilament carbon nanotubes would be added in a large amount, which will be accompanied with the degradation in the mechanical strength, etc., of the product.

In addition, since such monofilament carbon nanotubes come together mutually in the matrix and form aggregates as mentioned above, they can hardly form a fine network structure. Further, the electrical connection between the carbon nanotubes is caused only by a contingent event because the resin exists between the carbon nanotubes. Further, since the electrical connection depends on the condition of physical contact between the carbon nanotubes, it may come in a state close to an insulated state with a high resistance material when the degree of the contact is not enough, and thus, the electrical connection becomes considerably unstable. Therefore, even when the additive amount of the carbon nanotubes makes large, various shapes and various lengths of conductive paths which are formed by mutual contacts of monofilaments are hardly formed, and thus, it is difficult to obtain an ample effect of absorbing the electromagnetic waves which benefits from the characteristics of the loss material per se.

On the other hand, in the electromagnetic wave absorber according to the present invention, since the carbon fibrous structures each having a specific structure like a three dimensional network as mentioned later are added and dispersed in the matrix, various shapes and various lengths of conductive paths which are ascribable to the three dimensional network structures can be formed in the electromagnetic wave absorber. The most of contact points between the carbon fibers are made by the granular parts which are inherently owned by the carbon fibrous structures like the three dimensional networks and which are produced in a growth process of the carbon fibers as mentioned in detail later, although the rest of contact points are formed by the physical contacts of the carbon fibers as mentioned above. Thus, the most of the contact points show low resistivity and are very stable. Further, since the dispersibility of the carbon fibrous structures into the matrix is also good enough, it is possible to form conductive paths stably and efficiently even with a relatively small addition amount, without causing a fear that the resistance of the total system is greatly degraded. In addition, since the dispersibility is also good, it is possible to demonstrate a steady dispersion condition depending upon the addition amount, without being greatly influenced by the dispersion condition.

The conductive path ascribable to the three dimensional network structure as mentioned above can be drawn as an equivalent circuit of current loop consisting of resistance and capacitance. Since the conductive paths show various shapes and various lengths, the equivalent circuits corresponding to them have various resistances and various capacitances. Therefore, a layer capable of absorbing radio waves of various frequencies by the electromagnetic induction can be formed efficiently.

Thus, the electromagnetic wave absorber according to the present invention can demonstrate a stable absorbing property to electromagnetic waves of a very wide band in GHz band.

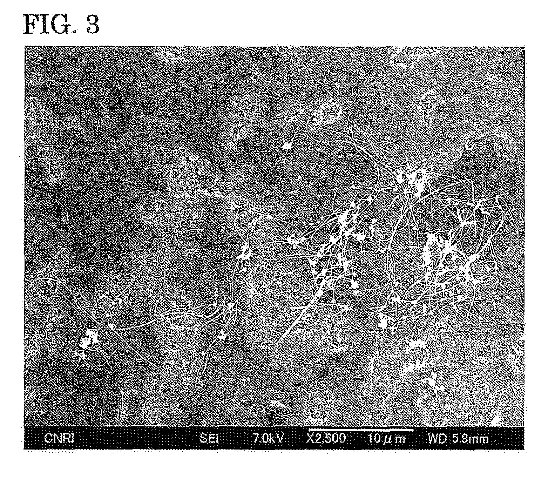

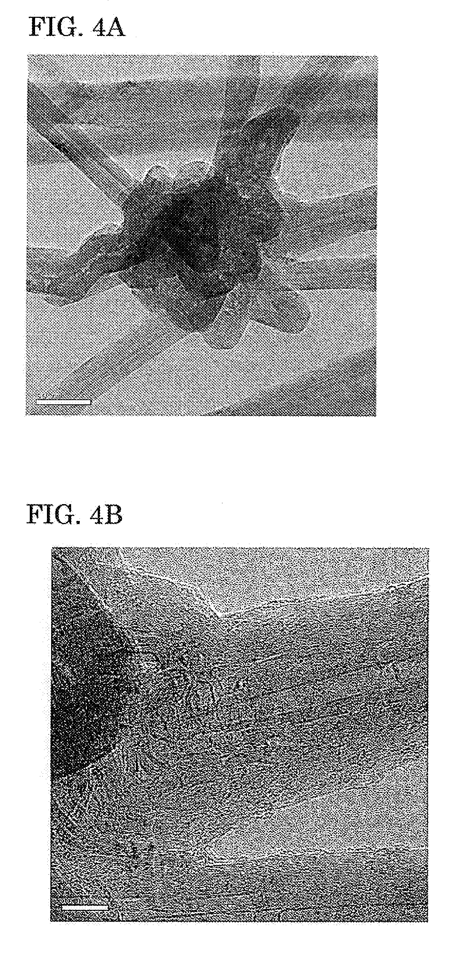

Next, the carbon fibrous structure which is used in the present invention will be described.
Each carbon fibrous structure to be used in the present invention is, as shown in SEM photo of Fig. 3 and TEM photos of Fig. 4A and 4B, composed of a thee-dimensionally network of carbon fibers each having an outside diameter of 15 - 100 nm, and a granular part with which the carbon fibers are bound together so that the concerned carbon fibers elongate outwardly from the granular part.

The reason for restricting the outside diameter of the carbon fibers which constitutes the carbon fibrous structure to a range of 15 nm to 100 nm is because when the outside diameter is less than 15 nm, the cross-sections of the carbon fibers do not have polygonal figures as described later. According to physical properties of the carbon fiber, the smaller the diameter of a fiber, the greater the number of carbon fibers will be for the same weight and/or the longer the length in the axial direction of the carbon fiber. This property would be followed by an enhanced electric conductivity. Thus, carbon fibrous structures having an outside diameter exceeding 100 nm are not preferred for use as modifiers or additives for a matrix such as a resin, etc. Particularly, it is more desirable for the outside diameter of the carbon fibers to be in the range of 20 - 70 nm. Carbon fibers that have a diameter within the preferable range and whose tubular graphene sheets are layered one by one in the direction that is orthogonal to the fiber axis, i.e., being of a multilayer type, can enjoy a high flexural rigidity and ample elasticity. In other words, such fibers would have a property of being easy to restore their original shape after undergoing any deformation. Therefore, even if the carbon fibrous structures have been compressed prior to being mixed into the matrix material, they tend to take a sparse structure in the matrix.

Incidentally, when annealing at a temperature of not less than 2400°C, the spacing between the layered graphene sheets becomes lesser and the true density of the carbon fiber is increased from 1.89 g/cm$^3$ to 2.1g/cm$^3$, and the cross sections of the carbon fiber perpendicular to the axis of carbon fiber come to show polygonal figures. As a result, the carbon fibers having such constitution become denser and have fewer defects in both the stacking direction and the surface direction of the graphene sheets that make up the carbon fiber, and thus their flexural rigidity (EI) can be enhanced.

Additionally, it is preferable that the outside diameter of the fine carbon fiber undergoes a change along the axial direction of the fiber. In the case that the outside diameter of the carbon fiber is not constant, but changed along the axial direction of the fiber, it would be expected that some anchor effect may be provided to the carbon fiber in the matrix material, and thus the migration of the carbon fiber in the matrix can be restrained, leading to improved dispersion stability.

Then, in the carbon fibrous structure used in the present invention, fine carbon fibers having a predetermined outside diameter and being configured three dimensionally are bound together by a granular part produced in a growth process of the carbon fibers so that the carbon fibers are elongated outwardly from the granular part. Since multiple carbon fibers are not only entangled each other, but tightly bound together at the granular part, the carbon fibers will not disperse as single fibers, but will be dispersed as intact bulky carbon fibrous structures when added to a matrix such as a resin. Since the fine carbon fibers are bound together by a granular part produced in the growth process of the carbon fibers in the carbon fibrous structure to be used in the present invention, the carbon fibrous structure itself can enjoy superior properties such as electric property. For instance, when determining electrical resistance under a certain pressed density, the carbon fibrous structure to be used in the present invention shows an extremely low resistivity, as compared with that of a simple aggregate of the fine carbon fibers and that of the carbon fibrous structures in which the fine carbon fibers are fixed at the contacting points with a carbonaceous material or carbonized substance therefrom after the synthesis of the carbon fibers. Thus, when the carbon fibrous structures added and distributed in a matrix, they can form good conductive paths within the matrix.

Since the granular part is produced in the growth process of the carbon fibers as mentioned above, the carbon - carbon bonds at the granular part are well developed. Further, the granular part appears to include mixed state of sp2- and sp3- bonds, although it is not clear accurately. After the synthesis process (in the "intermediate" or "first intermediate" defined hereinafter), the granular part and the fibrous parts are continuous mutually because of a structure comprising patch-like sheets of carbon atoms laminated together. Further, after the high temperature treatment, at least a part of graphene layers constituting the granular part is continued on graphene layers constituting the fine carbon fibers elongated outwardly from the granular part, as shown in Figs. 4A and 4B. In the carbon fibrous structure according to the present invention, as symbolized by such a fact that the graphene layers constituting the granular part is continued on the graphene layers constituting the fine carbon fibers, the granular part and the fine carbon fibers are bound together (at least in a part) by carbon crystalline structural bonds. Thus, strong couplings between the granular part and each fine carbon fiber are produced.

With respect to the carbon fibers, the condition of being "extended outwardly" from the granular part used herein means principally that the carbon fibers and granular part are linked together by carbon crystalline structural bonds as mentioned above, but does not means that they are apparently combined together by any additional binding agent (involving carbonaceous ones).

As traces of the fact that the granular part is produced in the growth process of the carbon fibers as mentioned above, the granular part has at least one catalyst particle or void therein, the void being formed due to the volatilization and elimination of the catalyst particle during the heating process after the generation process. The void (or catalyst particle) is essentially independent from hollow parts which are formed in individual fine carbon fibers which are extended outwardly from the granular part (although, a few voids which happened to be associated with the hollow part may be observed).

Although the number of the catalyst particles or voids is not particularly limited, it may be about 1 - 1000 a granular particle, more preferably, about 3 - 500 a granular particle. When the granular part is formed under the presence of catalyst particles the number of which is within the range mentioned above, the granular part formed can have a desirable size as mentioned later.

The per-unit size of the catalyst particle or void existing in the granular particle may be, for example, 1 - 100 nm, preferably, 2 - 40 nm, and more preferably, 3 - 15 nm.

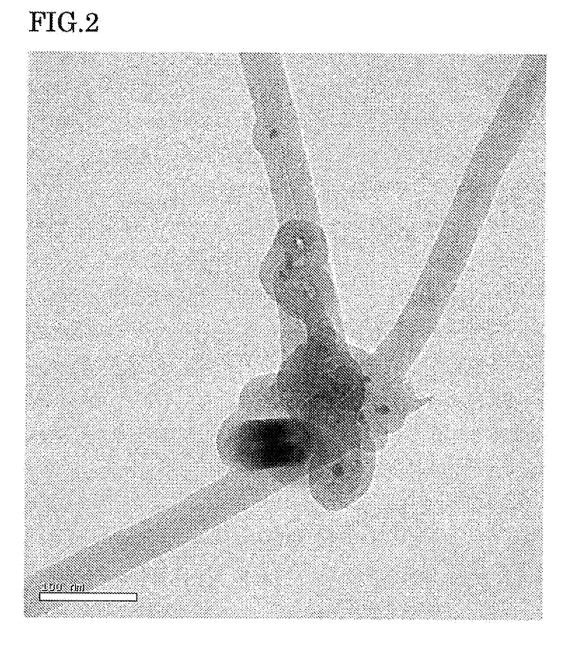

Furthermore, it is preferable that the diameter of the granular part is larger than the outside diameter of the carbon fibers as shown in Fig.2, although it is not specifically limited thereto. Concretely, for example, the diameter of granular part is 1.3 - 250 times larger than the outside diameter of the carbon fibers, preferably 1.5 - 100 times, and more preferably, 2.0-25 times larger, on average. When the granular part, which is the binding site of the carbon fibers, has a much larger particle diameter, that is, 1.3 times or more larger than the outer diameter of the carbon fibers, the carbon fibers that are elongated outwardly from the granular part have stronger binding force, and thus, even when the carbon fibrous structures are exposed to a relatively high shear stress during combining with a matrix such as resin, they can be dispersed as maintaining its three-dimensional carbon fibrous structures into the matrix. When the granular part has an extremely larger particle diameter, that is, exceeding 250 times of the outer diameter of the carbon fibers, the undesirable possibility that the fibrous characteristics of the carbon fibrous structure are lost will arise. Therefore, the carbon fibrous structure will not be suitable for an additive or compounding agent to various matrixes, and thus it is not desirable. The "particle diameter of the granular part" used herein is the value which is measured by assuming that the granular part, which is the binding site for the mutual carbon fibers, is one spherical particle.

Although the concrete value for the particle diameter of the granular part will be depended on the size of the carbon fibrous structure and the outer diameters of the fine carbon fibers in the carbon fibrous structure, for example, it may be 20 - 5000 nm, more preferably, 25 - 2000 nm, and most preferably, 30 - 500 nm, on average.

Furthermore, the granular part may be roughly globular in shape because the part is produced in the growth process of the carbon fibers as mentioned above. On average, the degree of roundness thereof may lay in the range of from 0.2 to <1, preferably, 0.5 to 0.99, and more preferably, 0.7 to 0.98.

Additionally, the binding of the carbon fibers at the granular part is very tight as compared with, for example, that in the structure in which mutual contacting points among the carbon fibers are fixed with carbonaceous material or carbonized substance therefrom. It is also because the granular part is produced in the growth process of the carbon fibers as mentioned above. Even under such a condition as to bring about breakages in the carbon fibers of the carbon fibrous structure, the granular part (the binding site) is maintained stably. Specifically, for example, when the carbon fibrous structures are dispersed in a liquid medium and then subjected to ultrasonic treatment with a selected wavelength and a constant power under a load condition by which the average length of the carbon fibers is reduced to about half of its initial value as shown in the Examples described later, the changing rate in the mean diameter of the granular parts is not more than 10%, preferably, not more than 5%, thus, the granular parts, i.e., the binding sites of fibers are maintained stably.

In carbon fibrous structures to be used in the present invention, it is preferable that the carbon fibrous structure has an area-based circle-equivalent mean diameter of 50 - 100 $\mu$m, and more preferably, 60 - 90 $\mu$m. The "area-based circle-equivalent mean diameter" used herein is the value which is determined by taking a picture of the outside shapes of the carbon fibrous structures with a suitable electron microscope, etc., tracing the contours of the respective carbon fibrous structures in the obtained picture using a suitable image analysis software, e.g., WinRoof™ (Mitani Corp.), and measuring the area within each individual contour, calculating the circle-equivalent mean diameter of each individual carbon fibrous structure, and then, averaging the calculated data.

Although it is not to be applied in all cases because the circle-equivalent mean diameter may be influenced by the kind of matrix material such as a resin to be complexed, the circle-equivalent mean diameter may become a factor by which the maximum length of a carbon fibrous structure upon combining with a matrix such as a resin is determined. In general, when the circle-equivalent mean diameter is not more than 50 $\mu$m, the electrical conductivity of the obtained composite may not be expected to reach a sufficient level, while when it exceeds 100 $\mu$m, an undesirable increase in viscosity may be expected to happen upon kneading of the carbon fibrous structures in the matrix. The increase in viscosity may be followed by failure of dispersion of the carbon fibrous structures into the matrix.

As mentioned above, the carbon fibrous structure according to the present invention has the configuration where the fine carbon fibers existing in three dimensional network state are bound together by the granular part (s) so that the carbon fibers are externally elongated from the granular part(s). When two or more granular parts are present in a carbon fibrous structure, wherein each granular part binds the fibers so as to form the three dimensional network, the mean distance between adjacent granular parts may be, for example, 0.5 - 300 $\mu$m, preferably, 0.5 - 100 $\mu$m, and more preferably, 1 - 50 $\mu$m. The distance between adjacent granular parts used herein is determined by measuring distance from the center of a granular part to the center of another granular part which is adjacent the former granular part. When the mean distance between the granular parts is not more than 0.5 $\mu$m, a configuration where the carbon fibers form an inadequately developed three dimensional network may be obtained. Therefore, it may become difficult to form good electrically conductive paths when the carbon fiber structures each having such an inadequately developed three dimensional network are added and dispersed to a matrix. Meanwhile, when the mean distance exceeds 300 $\mu$m, an undesirable increase in viscosity may be expected to happen upon adding and dispersing the carbon fibrous structures in the matrix. The increase in viscosity may result in an inferior dispersibility.

Furthermore, the carbon fibrous structure to be used in the present invention may exhibit a bulky, loose form in which the carbon fibers are sparsely dispersed, because the carbon fibrous structure is comprised of carbon fibers that are configured as a three dimensional network and are bound together by a granular part so that the carbon fibers are elongated outwardly from the granular part as mentioned above. It is desirable that the bulk density thereof is in the range of 0.0001 - 0.05 g/cm$^3$, more preferably, 0.001 - 0.02 g/cm$^3$. When the bulk density exceeds 0.05 g/cm$^3$, to attain an excellent electromagnetic wave absorbing property to the electromagnetic waves of a wide band would become difficult with a small dosage.

Furthermore, a carbon fibrous structure to be used in the present invention can enjoy good electric properties in itself, since the carbon fibers configured as a three dimensional network in the structure are bound together by a granular part produced in the growth process of the carbon fibers as mentioned above. For instance, it is desirable that a carbon fibrous structure to be used in the present invention has a powder electric resistance determined under a certain pressed density, 0.8 g/cm$^3$, of not more than 0.02 $\Omega \cdot$ cm, more preferably, 0.001 to 0.010 $\Omega \cdot$ cm. If the particle's resistance exceeds 0.02 $\Omega \cdot$ cm, it may become difficult to form good electrically conductive paths when the structures are added to a matrix such as a resin.

In order to enhance the strength and electric conductivity of a carbon fibrous structure to be used in the present invention, it is desirable that the graphene sheets that make up the carbon fibers have a small number of defects. In order to form equivalent electron circuit as mentioned above in a polymer which is a dielectric substance, the $I_D/I_G$ ratio of the carbon fiber determined by Raman spectroscopy should be not more than 10, concretely. Desirably, it is not more than 0.2, and more preferably, not more than 0.1. Incidentally, in Raman spectroscopic analysis, with respect to a large single crystal graphite, only the peak (G band) at 1580 cm$^{-1}$ appears. When the crystals are of finite ultrafine sizes or have any lattice defects, the peak (D band) at 1360 cm$^{-1}$ can appear. Therefore, when the intensity ratio (R=$I_{1360}/I_{1580}=I_D/I_G$) of the D band and the G band is below the selected range as mentioned above, it is possible to say that there is little defect in graphene sheets. When the $I_D/I_G$ ratio exceeds 10, the equivalent electron circuit which corresponds to a practically adequate absorption can not be formed.

Furthermore, it is desirable that the carbon fibrous structure to be used in the present invention has a combustion initiation temperature in air of not less than 750 °C, preferably, 800 °C - 900 °C. Such a high thermal stability would be brought about by the above mentioned facts that it has little defects and that the carbon fibers have a predetermined outside diameter.

A carbon fibrous structure having the above described, desirable configuration may be prepared as follows, although it is not limited thereto.

Basically, an organic compound such as a hydrocarbon is chemical thermally decomposed through the CVD process in the presence of ultrafine particles of a transition metal as a catalyst in order to obtain a fibrous structure (hereinafter referred to as an "intermediate"), and then the intermediate thus obtained undergoes a high temperature heating treatment.

As a raw material organic compound, hydrocarbons such as benzene, toluene, xylene; carbon monoxide (CO); and alcohols such as ethanol may be used. It is preferable, but not limited, to use as carbon sources at least two carbon compounds which have different decomposition temperatures. Incidentally, the words "at least two carbon compounds" used herein not only include two or more kinds of raw materials, but also include one kind of raw material that can undergo a reaction, such as hydrodealkylation of toluene or xylene, during the course of synthesis of the fibrous structure such that in the subsequent thermal decomposition procedure it can function as at least two kinds of carbon compounds having different decomposition temperatures.

When as the carbon sources at least two kinds of carbon compounds are provided in the thermal decomposition reaction system, the decomposition temperatures of individual carbon compounds may be varied not only by the kinds of the carbon compounds, but also by the gas partial pressures of individual carbon compounds, or molar ratio between the compounds. Therefore, as the carbon compounds, a relatively large number of combinations can be used by adjusting the composition ratio of two or more carbon compounds in the raw gas.

For example, the carbon fibrous structure to be used in the present invention can be prepared by using two or more carbon compounds in combination, while adjusting the gas partial pressures of the carbon compounds so that each compound performs mutually different decomposition temperature within a selected thermal decomposition reaction temperature range, and/or adjusting the residence time for the carbon compounds in the selected temperature region, wherein the carbon compounds to be selected are selected from the group consisting of alkanes or cycloalkanes such as methane, ethane, propanes, butanes, pentanes, hexanes, heptane, cyclopropane, cycrohexane, particularly, alkanes having 1 -7 carbon atoms; alkenes or cycloolefin such as ethylene, propylene, butylenes, pentenes, heptenes, cyclopentene, particularly, alkenes having 1 - 7 carbon atoms; alkynes such as acetylene, propyne, particularly, alkynes having 1 - 7 carbon atoms; aromatic or heteroaromatic hydrocarbons such as benzene, toluene, styrene, xylene, naphthalene, methyl naphtalene, indene, phenanthrene, particularly, aromatic or heteroaromatic hydrocarbons having 6 -18 carbon atoms; alcohols such as methanol, ethanol, particularly, alcohols having 1 -7 carbon atoms; and other carbon compounds involving such as carbon monoxide, ketones, ethers. Further, to optimize the mixing ratio can contribute to the efficiency of the preparation.

When a combination of methane and benzene is utilized among such combinations of two or more carbon compounds, it is desirable that the molar ratio of methane/benzene is >1 - 600, preferably, 1.1 - 200, and more preferably 3 -100. The ratio is for the gas composition ratio at the inlet of the reaction furnace. For instance, when as one of carbon sources toluene is used, in consideration of the matter that 100% of the toluene decomposes into methane and benzene in proportions of 1:1 in the reaction furnace, only a deficiency of methane may be supplied separately. For example, in the case of adjusting the methane / benzene molar ratio to 3, 2 mol methane may be added to 1 mol toluene. As the methane to be added to the toluene, it is possible to use the methane which is contained as an unreacted form in the exhaust gas discharged from the reaction furnace, as well as a fresh methane specially supplied.

Using the composition ratio within such a range, it is possible to obtain the carbon fibrous structure in which both the carbon fiber parts and granular parts are efficiently developed.

Inert gases such as argon, helium, xenon; and hydrogen may be used as an atmosphere gas.

A mixture of transition metal such as iron, cobalt, molybdenum, or transition metal compounds such as ferrocene, metal acetate; and sulfur or a sulfur compound such as thiophene, ferric sulfide; may be used as a catalyst.

The intermediate may be synthesized using a CVD process with hydrocarbon or etc., which has been conventionally used in the art. The steps may comprise gasifing a mixture of hydrocarbon and a catalyst as a raw material, supplying the gasified mixture into a reaction furnace along with a carrier gas such as hydrogen gas, etc., and undergoing thermal decomposition at a temperature in the range of 800 °C - 1300 °C. By following such synthesis procedures, the product obtained is an aggregate, which is of several to several tens of centimeters in size and which is composed of plural carbon fibrous structures (intermediates), each of which has a three dimensional configuration where fibers having 15 - 100 nm in outside diameter are bound together by a granular part that has grown around the catalyst particle as the nucleus.

The thermal decomposition reaction of the hydrocarbon raw material mainly occurs on the surface of the catalyst particles or on growing surface of granular parts that have grown around the catalyst particles as the nucleus, and the fibrous growth of carbon may be achieved when the recrystallization of the carbons generated by the decomposition progresses in a constant direction. When obtaining carbon fibrous structures according to the present invention, however, the balance between the thermal decomposition rate and the carbon fiber growth rate is intentionally varied. Namely, for instance, as mentioned above, to use as carbon sources at least two kinds of carbon compounds having different decomposition temperatures may allow the carbonaceous material to grow three dimensionally around the granular part as a centre, rather than in one dimensional direction. The three dimensional growth of the carbon fibers depends not only on the balance between the thermal decomposition rate and the growing rate, but also on the selectivity of the crystal face of the catalyst particle, residence time in the reaction furnace, temperature distribution in the furnace, etc. The balance between the decomposition rate and the growing rate is affected not only by the kinds of carbon sources mentioned above, but also by reaction temperatures, and gas temperatures, etc. Generally, when the growing rate is faster than the decomposition rate, the carbon material tends to grow into fibers, whereas when the thermal decomposition rate is faster than the growing rate, the carbon material tends to grow in peripheral directions of the catalyst particle. Accordingly, by changing the balance between the thermal decomposition rate and the growing rate intentionally, it is possible to control the growth of carbon material to occur in multi-direction rather than in single direction, and to produce three dimensional structures that are related to the present invention. In order to form the above mentioned three-dimensional configuration, where the fibers are bound together by a granular part, with ease, it is desirable to optimize the compositions such as the catalyst used, the residence time in the reaction furnace, the reaction temperature and the gas temperature.

With respect to the method for preparing the carbon fibrous structure to be used in the present invention with efficiency, as another approach to the aforementioned one that two ormore carbon compounds which have mutually different

decomposition temperature are used in an appropriate mixing ratio, there is an approach that the raw material gas supplied into the reaction furnace from a supply port is forced to form a turbulent flow in proximity to the supply port. The "turbulent flow" used herein means a furiously irregular flow, such as flow with vortexes.

In the reaction furnace, immediately after the raw material gas is supplied into the reaction furnace from the supply port, metal catalyst fine particles are produced by the decomposition of the transition metal compound as the catalyst involved in the raw material gas. The production of the fine particles is carried out through the following steps. Namely, at first, the transition metal compound is decomposed to make metal atoms, then, plural number of, for example, about one hundred of metal atoms come into collisions with each other to create a cluster. At the created cluster state, it can not function as a catalyst for the fine carbon fiber. Then, the clusters further are aggregated by collisions with each other to grow into a metal crystalline particle of about 3 - 10 nm in size, and which particle comes into use as the metal catalyst fine particle for producing the fine carbon fiber.

During the catalyst formation process as mentioned above, if the vortex flows belonging to the furiously turbulent flow are present, it is possible that the collisions of metal atoms or collisions of clusters become more vigorously as compared with the collisions only due to the Brownian movement of atoms or collisions, and thus the collision frequency per unit time is enhanced so that the metal catalyst fine particles are produced within a shorter time and with higher efficiency. Further, since concentration, temperature, etc. are homogenized by the force of vortex flow, the obtained metal catalyst fine particles become uniform in size. Additionally, during the process of producing metal catalyst fine particles, a metal catalyst particles' aggregate in which numerous metal crystalline particles was aggregated by vigorous collisions with the force of vortex flows can be also formed. Since the metal catalyst particles are rapidly produced as mentioned above, the decomposition of carbon compound can be accelerated so that an ample amount of carbonaceous material can be provided. Whereby, the fine carbon fibers grow up in a radial pattern by taking individual metal catalyst particles in the aggregate as nuclei. When the thermal decomposition rate of a part of carbon compounds is faster than the growing rate of the carbon material as previously described, the carbon material may also grow in the circumferential direction so as to form the granular part around the aggregate, and thus the carbon fiber structure of the desired three dimensional configuration may be obtained with efficiency. Incidentally, it may be also considered that there is a possibility that some of the metal catalyst fine particles in the aggregate are ones that have a lower activity than the other particles or ones that are deactivated on the reaction. If non-fibrous or very short fibrous carbon material layers grown by such catalyst fine particles before or after the catalyst fine particles aggregate are present at the circumferential area of the aggregate, the granular part of the carbon fiber structure to be used in the present invention may be formed.

The concrete means for creating the turbulence to the raw material gas flow near the supply port for the raw material gas is not particularly limited. For example, it is adaptable to provide some type of collision member at a position where the raw material gas flow introduced from the supply port can be interfered by the collision section. The shape of the collision section is not particularly limited, as far as an adequate turbulent flow can be formed in the reaction furnace by the vortex flow which is created at the collision section as the starting point. For example, embodiments where various shapes of baffles, paddles, tapered tubes, umbrella shaped elements, etc., are used singly or in varying combinations and located at one or more positions may be adaptable.

The intermediate, obtained by heating the mixture of the catalyst and hydrocarbon at a constant temperature in the range of 800 °C - 1300°C, has a structure that resembles sheets of carbon atoms laminated together, (and being still in a half-raw, or incomplete condition). When analyzed with Raman spectroscopy, the D band of the intermediate is very large and many defects are observed. Further, the obtained intermediate is associated with unreacted raw materials, nonfibrous carbon, tar moiety, and catalyst metal.

Therefore, the intermediate is subjected to a high temperature heat treatment at 2400 - 3000 °C using a proper method in order to remove such residues from the intermediate and to produce the intended carbon fibrous structure with few defects.

For instance, the intermediate may be heated at 800 - 1200 °C to remove the unreacted raw material and volatile flux such as the tar moiety, and thereafter annealed at a high temperature of 2400 - 3000 °C to produce the intended structure and, concurrently, to vaporize the catalyst metal, which is included in the fibers, to remove it from the fibers. In this process, it is possible to add a small amount of a reducing gas and carbon monoxide into the inert gas atmosphere to protect the carbon structures.

By annealing the intermediate at a temperature of 2400 - 3000 °C, the patch-like sheets of carbon atoms are rearranged to associate mutually and then form multiple graphene sheet-like layers.

After or before such a high temperature heat treatment, the aggregates may be subjected to crushing in order to obtain carbon fibrous structures, each having an area-based circle-equivalent mean diameter of several centimeters. Then, the obtained carbon fibrous structures may be subjected to pulverization in order to obtain the carbon fibrous structures having an area-based circle-equivalent mean diameter of 50 - 100 $\mu$m. It is also possible to perform the pulverization directly without crushing. On the other hand, the initial aggregates involving plural carbon fibrous structures to be used in the present invention may also be granulated for adjusting shape, size, or bulk density to one's suitable for using a particular application. More preferably, in order to utilize effectively the above structure formed from the reaction, the annealing would be performed in a state such that the bulk density is low (the state that the fibers are extended as much as they can and the voidage is sufficiently large). Such a state may contribute to improved electric conductivity of a resin matrix.

Moreover, the defect in the graphite structures in the ultrathin carbon fiber induces scattering of the conduction electron having spin, and disturbs the systematic magneto-resistance effect as mentioned above. For instance, when the signal intensity ratio $I_D/I_G$ of a peak (G band) at 1580 cm$^{-1}$ and a peak (D band) at 1360 cm$^{-1}$, as determined by Raman spectroscopy, is used as an index of this defect, it is preferable that the signal intensity ratio is not more than 0.2, more preferably, not more than 0.1. Ultrathin carbon fiber which has the defects that indicates a value of higher than the above mentioned bound has a fear of deteriorating the electromagnetic wave absorption effect and lowering the absorbable frequency band region.

Incidentally, in the Raman spectroscopy, a large single crystal graphite has only a peak (G band) at 1580 cm$^{-1}$. When the graphite crystals are small or have any lattice defects, a peak (D band) at 1360 cm$^{-1}$ can appear. Thus, when the intensity ratio ($R=I_{1360}/I_{1580}=I_D/I_G$) of the D band and the G band is below the bound defined above, the graphene sheets have little defect.

When the resistance equivalent body formed by the negative magneto-resistance constructs conductive pathways throughout a macro region, the electromagnetic wave absorption capability increases. In order to construct the conductive pathways with a lesser density of the ultrathin carbon fibers, it is desirable that the diameter and the aspect ratio (length/diameter) of ultrathin carbon fibers are in the range of 15-100nm, and the range of not less than 50, respectively. It is because more ultrathin carbon fibers would be necessitated for constructing the conductive pathways, and a fear that the characteristics originally owned by the matrix, per se, are ruined may arise.

When the above mentioned carbon fibrous structures are combined with an organic polymer, an inorganic material, etc., the carbon fibrous structures can construct a network in the matrix of the above mentioned materials, and thus the electromagnetic wave absorber according to the present invention is provided. An excellent electromagnetic wave absorption capability, particularly, that for the electromagnetic waves of GHz band, is provided by using the carbon fibrous structures, regardless of the kind of matrix used which involves various materials from the materials of low dielectric constants to the metals.

Although the ratio of the carbon fibrous structures to be added to the matrix in order to prepare the electromagnetic wave absorber according to the present invention may be varied by the kind of the matrix used, and by the kind of the applied usage of the electromagnetic wave absorber, it may be about 0.01 % - about 25 % by weight, preferably, not more than 5 % by weight, based on the total weight of the electromagnetic wave absorber. Further, from the viewpoint of not deteriorating the characteristics of the matrix, it is more preferable to be not more than 1 % by weight. Even when the content of the carbon fibrous structures as the loss material is extremely low as mentioned above, the electromagnetic wave absorber can exhibit an adequate electromagnetic wave absorption capability because of the easiness of the formation of the network in the matrix and the excellent dispersibility.

Although the organic polymer used as the matrix is not especially limited, for instance, various thermoplastic resins such as polypropylene, polyethylene, polystyrene, polyvinyl chloride, polyacetal, polyethylene terephthalate, polycarbonate, polyvinylacetate, polyamide, polyamide imide, polyether imide, polyether ether ketone, polyvinyl alcohol, poly phenylene ether, poly(meth)acrylate, and liquid crystal polymer; and various thermosetting resins such as epoxy resin, vinyl ester resin, phenol resin, unsaturated polyester resin, furan resins, imide resin, urethane resin, melamine resin, silicone resin and urea resin; as well as various elastomers such as natural rubber, styrene butadiene rubber (SBR), butadiene rubber (BR), polyisoprene rubber (IR), ethylene-propylene rubber (EPDM), nitrile rubber (NBR), polychloroprene rubber (CR), isobutylene isoprene rubber (IIR), polyurethane rubber, silicone rubber, fluorine rubber, acrylic rubber (ACM), epichlorohydrin rubber, ethylene acrylic rubber, norbornene rubber and thermoplastic elastomer can be enumerated as the organic polymer.

Among these organic polymers, polymers having a relative dielectric constant of not more than 15, preferably, a relative dielectric constant of 2 - 15, more preferably, a relative dielectric constant of 4 - 15 are desirable. When the relative dielectric constant exceeds 15, the obtained composite material with the carbon fibrous structures behaves like a metal, and thus, most of the incoming electromagnetic waves would be reflected by the composite material. Hence, the composite material can hardly function as the absorber. On the other hand, when the relative dielectric constant is not more than 2, the real dielectric constant in the complex dielectric constant with respect to 1 - 50 GHz band becomes low, and a fear that the composite material can not show ample tangent losses for absorbing the electromagnetic waves in such a band will arise.

Furthermore, the organic polymer maybe in various forms of composition, such as adhesive, fibers, paint, ink, etc.

That is, for example, the matrix may be an adhesive agent such as epoxy type adhesive, acrylic type adhesive, urethane type adhesive, phenol type adhesive, polyester type adhesive, polyvinyl chloride type adhesive, urea type adhesive, melamine type adhesive, olefin type adhesive, acetic acid vinyl type adhesive, hotmelt type adhesive, cyano acrylate type adhesive, rubber type adhesive, cellulose type adhesive, etc.; fibers such as acrylic fibers, acetate fibers, aramid fiber, nylon fibers, novoloid fibers, cellulose fibers, viscose rayon fibers, vinylidene fibers, vinylon fibers, fluorine fibers, polyacetal fibers, polyurethane fibers, polyester fibers, polyethylene fibers, polyvinyl chloride fibers, polypropylene fibers, etc.; or a paint such as phenol resin type, alkyd type, epoxy type, acrylic resin type, unsaturated polyester type, polyurethane type, silicon type, fluorine resin type, synthetic resin emulsion type, etc.

As the inorganic material, for instance, various metals, ceramic materials and inorganic oxide polymers may be enumerated. As preferred concrete examples, metals such as aluminum, magnesium, lead, cupper, tungsten, titanium, niobium, hafnium, vanadium, and alloys thereof and blends thereof; carbon materials such as carbon-carbon composite; glass, glass fiber, flat glass and other forming glass; and silicate ceramics and other heat resisting ceramics, e.g. aluminum oxide, silicon carbide, magnesium oxide, silicone nitride and boron nitride can be enumerated.

Moreover, in the electromagnetic wave absorber according to the present invention, it is possible to include other filling agents in addition to the above mentioned carbon fibrous structures in order to modify the electromagnetic wave absorbing material properly. As such a filling agent, for instance, metallic minute particles, silica, calcium carbonate, magnesium carbonate, carbon black, glass fibers, and carbon fibers can be enumerated. These filling agents may be used singly or in any combination of more than two agents. Although the presence or absence of these filling agents varies the mechanical characteristics and the thermal characteristics, the fact is hardly influential in the electromagnetic wave absorption capability.

Preparation of the composite can be performed in accordance with any known method by selecting an optimal method depending on the kind of the matrix used, for instance, in the case of an organic polymer, it may be accomplished by kneading under melted condition, dispersion into a thermosetting resin composition, dispersion into a lacquer, etc, and in the case of an inorganic material, it may be accomplished by particle sintering, sol - gel method, dispersion in a molten metal, etc. Even in any cases, since the carbon fibrous structures can be dispersed satisfactorily in the matrix and can form networks, the product can exhibit an excellent electromagnetic wave absorption capability. Further, even when an organic polymer having elasticity or flexibility is used as the matrix, and the matrix is bent and deformed, there is little possibility of causing rupture of the carbon fibrous structures. Because, each of carbon fibrous structures added in the matrix has a three dimensional configuration which is rich in elasticity. Therefore, the fluctuations in the properties of the electromagnetic wave absorber due to the deformation can be repressed at low.

The thus obtained electromagnetic wave absorption material according to the present invention can remarkably reduce the influence of the electromagnetic waves, when it is processed into a film, a seat or a casing product for any apparatus and it is used at an appropriate place.

Incidentally, when the electromagnetic wave absorbing material is formed as a film, for instance, it can be formed by coating the electromagnetic wave absorbing material in an appropriate shape onto the surface of a substrate made of a dielectric substance.

As the substrate, plates, films and any three dimensional shapes may be usable. However, from the viewpoint of low-profile and easy-handling of the finished electromagnetic wave absorber, it is preferable to use the plate-like or film-like substrate. In addition, it is also possible that the electromagnetic wave absorber according to the present invention can be constituted by forming a film-like electromagnetic wave absorbing layer on one of frameworks of various devices, partition plates, printed boards, etc., as the substrate. As the substrate of dielectric substance, various glasses, various plastics, silicon, ceramics such as alumina, crystals such as sapphire, etc., can be used, although the substrate is not particularly limited thereto. Even when a substrate having elasticity or flexibility is used as the substrate, and the substrate is bent and deformed, there is little possibility of causing rupture of the carbon fibrous structures. Because, each of carbon fibrous structures in the electromagnetic wave absorbing layer formed on the substrate has a three dimensional configuration which is rich in elasticity. Therefore, the fluctuations in the properties of the electromagnetic wave absorber due to the deformation can be repressed at low.

The configuration of the film-like electromagnetic wave absorbing layer formed on the substrate can be determined by the frequency of the electromagnetic wave to be absorbed, although it is not particularly limited thereto. Although it is possible to form the layer onto the whole surface of the substrate as a matter of course, it is also possible that the layer is formed by arranging predetermined film-like block patterns so as to be separated mutually. As such a block pattern, for instance, polygonal shapes capable of constituting a closest packing in the layout (triangle, quadrangle, hexagon), or other shapes such as fractal, Sierpinski triangle, etc., may be adaptable, although the pattern is not particularly limited thereto.

For instance, when an application for cellular phone or wireless LAN is considered, the frequencies of the radio waves to be absorbed are 800 MHz - 2.5 GHz, and thus each individual shape of the electromagnetic wave absorbing layer may have an area of not less than 1.2 cm$^2$ and not more than 10 cm$^2$, and be formed as a polygonal shape capable of constituting a closest packing in the layout (triangle, quadrangle, hexagon), and when an application for ETC (Electronic Toll Collection System) of high frequencies is considered, the frequencies of the radio waves to be absorbed are 5.8 GHz - 10 GHz, and thus each individual shape of the electromagnetic wave absorbing layer may have an area of not less than 0.10 cm$^2$ and not more than 0.25 cm$^2$, and be formed as a polygonal shape capable of constituting a closest packing in the layout. Incidentally, since the electromagnetic wave absorbing layer according to the present invention is characterized in that it can cope with a wide band in high frequency range, the electromagnetic wave absorbing layer readied for cellular phone or wireless LAN can be also utilized as the electromagnetic wave absorber which is aimed at higher frequencies. Further, with respect to the gap between the adjacent block patterns, it is preferable to be set to a distance of not more than one-half of the wavelength of electromagnetic wave of the minimum frequency which belongs to the electromagnetic waves to be absorbed.

The electromagnetic wave absorber according to the present invention may be further provided with a grounding electrode. When the electromagnetic wave absorbing layer as mentioned above is formed as a film on one surface side of the substrate, the grounding electrode can be arranged on the other surface side of the substrate which is not the surface side of supporting the electromagnetic wave absorbing layer. When the electromagnetic wave absorber is formed as a sheet, it is preferable that the grounding electrode is placed with lying a dielectric material between the electromagnetic wave absorber and the grounding electrode. As the grounding electrode, for instance, metal plates or metal films, etc., are usable.

## EXAMPLES

Hereinafter, this invention will be illustrated in detail by practical examples. However, it is to be understood that the examples are given for illustrative purpose only, and the invention is not limited thereto. Incidentally, the respective physical properties described in the following examples and controls are measured by the following protocols.

<Area based circle-equivalent mean diameter>

First, a photograph of pulverized product was taken with SEM. On the taken SEM photo, only carbon fibrous structures with a clear contour were taken as objects to be measured, and broken ones with unclear contours were omitted. Using all carbon fibrous structures that can be taken as obj ects in one single field of view (approximately, 60 - 80 pieces), about 200 pieces in total were measured with three fields of views. Contours of the individual carbon fibrous structures were traced using the image analysis software, WinRoof™ (trade name, marketed by Mitani Corp.), and area within each individual contour was measured, circle-equivalent mean diameter of each individual carbon fibrous structure was calculated, and then, the calculated data were averaged to determine the area based circle-equivalent mean diameter.

<Measurement of Bulk density>

1 g of powder was placed into a 70 mm caliber transparent cylinder equipped with a distribution plate, then air supply at 0.1 Mpa of pressure, and 1.3 liter in capacity was applied from the lower side of the distribution plate in order to blow off the powder and thereafter allowed the powder to settle naturally. After the fifth air blowing, the height of the settled powder layer was measured. Any 6 points were adopted as the measuring points, and the average of the 6 points was calculated in order to determine the bulk density.

<Raman spectroscopic analysis>

The Raman spectroscopic analysis was performed with the equipment LabRam 800 manufactured by HORIBA JOBIN YVON, S.A.S., and using 514 nm the argon laser.

<TG combustion temperature>

Combustion behavior was determined using TG-DTA manufactured by MAC SCIENCE CO. LTD., at air flow rate of 0.1 liter/minute and heating rate of 10 °C/minute. When burning, TG indicates a quantity reduction and DTA indicates an exothermic peak. Thus, the top position of the exothermic peak was defined as the combustion initiation temperature.

<X ray diffraction>

Using the powder X ray diffraction equipment (JDX3532, manufactured by JEOL Ltd.), carbon fibrous structures after annealing processing were examined. Kα ray which was generated with Cu tube at 40 kV, 30 mA was used, and the measurement of the spacing was performed in accordance with the method defined by The Japan Society for the Promotion of Science (JSPS), described in "Latest Experimental Technique For Carbon Materials (Analysis Part)", Edited by Carbon Society of Japan, 2001), and as the internal standard silicon powder was used.

<Particle's resistance and decompressibility>

1 g of CNT powder was scaled, and then press-loaded into a resinous die (inner dimensions: 40 L, 10 W, 80 H (mm)), and the displacement and load were read out. A constant current was applied to the powder by the four-terminal method, and in this condition the voltage was measured. After measuring the voltage until the density come to $0.9 g/cm^3$, the applied pressure was released and the density after decompression was measured. Measurements taken when the powder was compressed to 0.5, 0.8 or 0.9 $g/cm^3$ were adopted as the particle's resistance.

<Mean diameter and roundness of the granular part, and ratio of the granular part to the fine carbon fiber>

First, a photograph of the carbon fibrous structures was taken with SEM in an analogous fashion as in the measurement of area based circle-equivalent mean diameter. On the taken SEM photo, only carbon fibrous structures with a clear contour were taken as objects to be measured, and broken ones with unclear contours were omitted. Using all carbon fibrous structures that can be taken as objects in one single field of view (approximately, 60 - 80 pieces), about 200 pieces in total were measured with three fields of views.

On the carbon fibrous structures to be measured, assuming each individual granular part which is the binding point of carbon fibers to be a particle, contours of the individual granular parts were traced using the image analysis software, WinRoof ™ (trade name, marketed by Mitani Corp.), and area within each individual contour was measured, circle-equivalent mean diameter of each individual granular part was calculated, and then, the calculated data were averaged to determine the area based circle-equivalent mean diameter. Roundness (R) was determined by inputting value of the area(A) within each individual contour computed by the above and a measured value of each individual contour's length (L) to the following equation to calculate the roundness of each individual granular part, and then, averaging the calculated data.

[Numerical Formula 1]     $R = A * 4\pi / L^2$

Further, the outer diameter of the fine carbon fibers in the individual carbon fibrous structures to be measured were determined, and then, from the outer diameter determined and the circle-equivalent mean diameter of the granular part calculated as above, the ratio of circle-equivalent mean diameter to the outer diameter of the fine carbon fiber was calculated for each individual carbon fibrous structure, and then the data obtained are averaged.

<Mean distance between granular parts>

First, a photograph of the carbon fibrous structures was taken with SEM in an analogous fashion as in the measurement of area based circle-equivalent mean diameter. On the taken SEM photo, only carbon fibrous structures with a clear contour were taken as objects to be measured, and broken ones with unclear contours were omitted. Using all carbon fibrous structures that can be taken as objects in one single field of view (approximately, 60 - 80 pieces), about 200 pieces in total were measured with three fields of views.

On the carbon fibrous structures to be measured, all places where the granular parts were mutually linked with a fine carbon fiber were found out. Then, at the respective places, the distance between the adjacent granular parts which were mutually linked with the fine carbon fiber (the length of the fine carbon fiber including the center of a granular part at one end to the center of another granular part at another end) was measured, and then the data obtained were averaged.

<Destruction test for carbon fibrous structure>

To 100ml of toluene in a lidded vial, the carbon fiber structures were added at a rate of 30 $\mu$g/ml in order to prepare the dispersion liquid sample of the carbon fibrous structure.

To the dispersion liquid sample of the carbon fibrous structure thus prepared, Ultrasound was applied using a ultrasonic cleaner (manufactured by SND Co., Ltd., Trade Name: USK-3) of which generated frequency was 38 kHz and power was 150 w, and the change of the carbon fibrous structure in the dispersion liquid was observed in the course of time aging.

First, 30 minutes after the application of ultrasound was started, a 2 ml constant volume aliquot of the dispersion sample was pipetted, and the photo of the carbon fibrous structures in the aliquot was taken with SEM. On the obtained SEM photo, 200 pieces of fine carbon fibers in the carbon fibrous structures (fine carbon fibers at least one end of which is linked to the granular part) were selected randomly, then the length of the each individual selected fine carbon fibers was measured, and mean length $D_{50}$ was calculated. The mean length calculated is taken as the initial average fiber length.

Meanwhile, on the obtained SEM photo, 200 pieces of granular parts which each were the binding point of carbon fibers in the carbon fibrous structures were selected randomly. Assuming each individual selected granular part to be a particle, contours of the individual granular parts were traced using the image analysis software, WinRoof™ (trade name, marketed by Mitani Corp.), and area within each individual contour was measured, circle-equivalent mean diameter of each individual granular part was calculated, and then, $D_{50}$ mean value thereof is calculated. The $D_{50}$ mean value calculated was taken as the initial average diameter of the granular parts.

Thereafter, according to the same procedure, a 2 ml constant volume aliquot of the dispersion sample was pipetted every constant periods, and the photo of the carbon fibrous structures in the each individual aliquot was taken with SEM, and the mean length $D_{50}$ of the fine carbon fibers in the carbon fibrous structure and the mean diameter $D_{50}$ of the granular part in the carbon fibrous structure were calculated individually.

At the time when the mean length $D_{50}$ of the fine carbon fibers comes to be about half the initial average fiber length (in the following Examples, 500 minutes after the application of ultrasound is stated.), the mean diameter $D_{50}$ of the granular part was compared with the initial average diameter of the granular parts in order to obtain the rate of variability (%) thereof.

<Conductivity>

In a obtained specimen, using 4-pin probe type low resistivity meter (LORESTA-GP, manufactured by Mitsubishi Chemical), the resistance (Q) at nine points of the surface was measured, then the measured values were converted into those of volume resistivity ($\Omega\cdot$cm), and then average was calculated.

<Electromagnetic wave absorption capability>

Electromagnetic wave absorption capability to the electromagnetic waves of 1 - 20 GHz was determined by examinations for the plane wave attenuation property (according to the Japan National Defense Standards, "electromagnetic shielding room test method").

This capability was determined by using an instrument construction which equipped with a R/S SMR20 type signal generator (manufactured by ROHDE & SCHWARZ), an Agilent E7405 type spectrum analyzer (manufactured by Agilent Technology) an 3115 (a transmitter TX and a receiver RX), and the distances of antenna - sample - antenna are set to 500 mm + 500mm. Incidentally, the sample was placed at the prescribed position when the sample was set at an 395 mm x 395 mm open flame portion which was provided in the shielding wall which was placed between the two antennas.

Synthetic Example 1

By the CVD process, carbon fibrous structures were synthesized from toluene as the raw material. The synthesis was carried out in the presence of a mixture of ferrocene and thiophene as the catalyst, and under the reducing atmosphere of hydrogen gas. Toluene and the catalyst were heated to 380 °C along with the hydrogen gas, and then they were supplied to the generation furnace, and underwent thermal decomposition at 1250 °C in order to obtain the carbon fibrous structures (first intermediate).

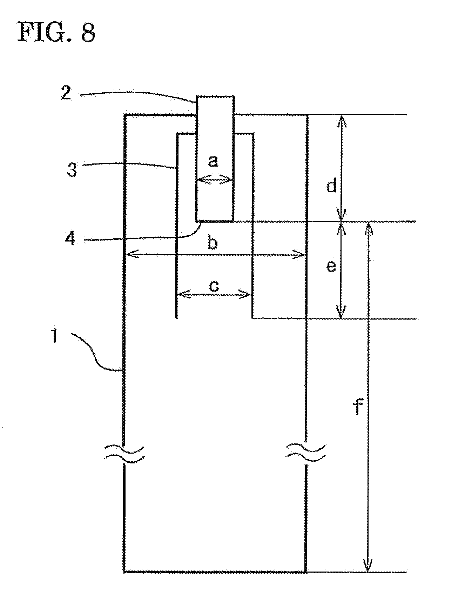

The generation furnace used for the carbon fibrous structures (first intermediate) is illustrated schematically in Fig. 8. As shown in Fig. 8, the generation furnace 1 was equipped at the upper part thereof with a inlet nozzle 2 for introducing the raw material mixture gas comprising toluene, catalyst and hydrogen gas as aforementioned into the generation furnace 1. Further, at the outside of the inlet nozzle 2, a cylindrical-shaped collision member 3 was provided. The collision member 3 was set to be able to interfere in the raw material gas flow introduced from the raw material supply port 4 located at the lower end of the inlet nozzle 2. In the generation furnace 1 used in this Example, given that the inner diameter of the inlet nozzle 2, the inner diameter of the generation furnace 1, the inner diameter of the cylindrical-shaped collision member 3, the distance from the upper end of the generation furnace 1 to the raw material mixture gas supply port 4, the distance from the raw material mixture gas supply port 4 to the lower end of the collision member 3, and the distance from the raw material mixture gas supply port 4 to the lower end of the generation furnace 1 were "a", "b", "c", "d", "e", and "f", respectively, the ratio among the above dimensions was set as a:b:c:d:e:f = 1.0:3.6:1.8:3.2:2.0: 21.0. The raw material gas supplying rate to the generation furnace was 1850 NL/min., and the pressure was 1.03 atms.

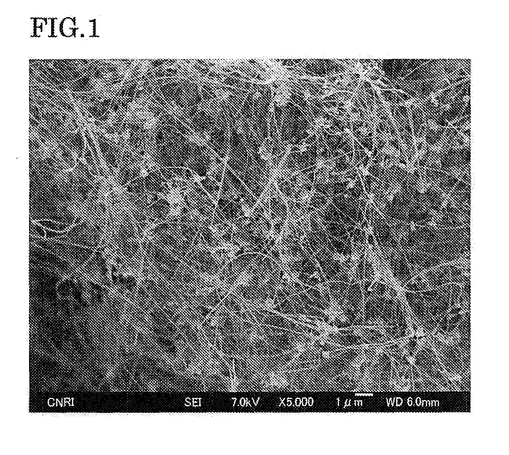

The synthesized first intermediate was baked at 900 °C in nitrogen gas in order to remove hydrocarbons such as tar and to obtain a second intermediate. The R value of the second intermediate measured by the Raman spectroscopic analysis was found to be 0.98. Sample for electron microscopes was prepared by dispersing the first intermediate into toluene. Figs. 1 and 2 show SEM photo and TEM photo of the sample, respectively.

Further, the second intermediate underwent a high temperature heat treatment at 2600 °C. The obtained aggregates of the carbon fibrous structures underwent pulverization using an air flow pulverizer in order to produce the carbon fibrous structures to be used in the present invention. A sample for electron microscopes was prepared by dispersing ultrasonically the obtained carbon fibrous structures into toluene. Fig. 3, and Figs. 4A and 4B show SEM photo and TEM photos of the sample, respectively.

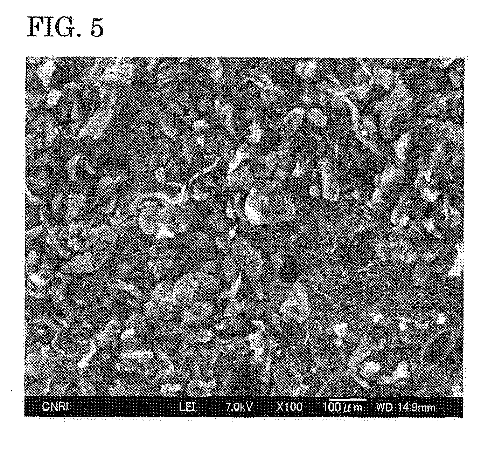

Fig. 5 shows SEM photo of the obtained carbon fibrous structures as mounted on a sample holder for electron microscope, and Table 1 shows the particle distribution of obtained carbon fibrous structures.

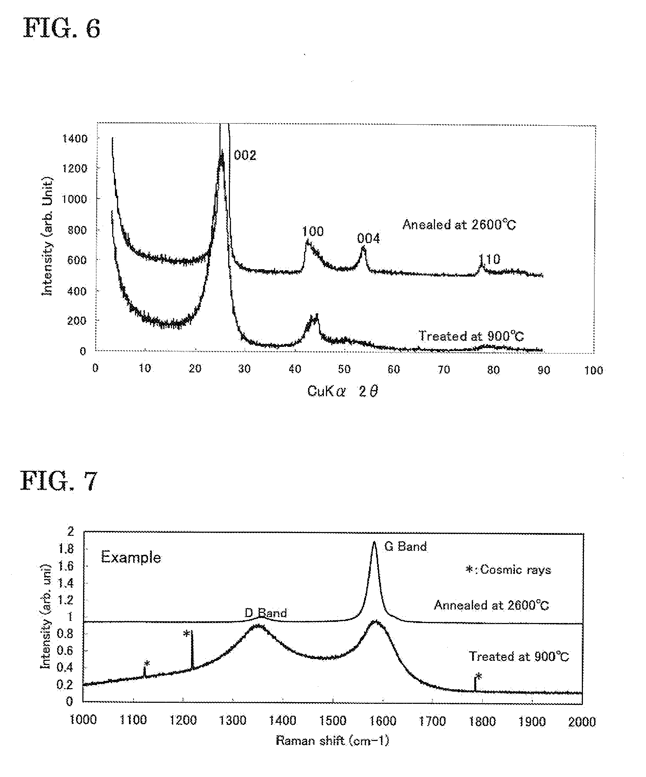

Further, X-ray diffraction analysis and Raman spectroscopic analysis were performed on the carbon fibrous structure before and after the high temperature heat treatment in order to examine changes in these analyses. The results are shown in Figs. 6 and 7, respectively.

Additionally, it was found that the carbon fibrous structures had an area based circle-equivalent mean diameter of 72.8 $\mu$m, bulk density of 0.0032 g/cm$^3$, Raman $I_D/I_G$ ratio of 0.090, TG combustion temperature of 786 °C, spacing of 3.383 A, particle's resistance of 0.0083 $\Omega$·cm, and density after decompression of 0.25 g/cm$^3$. The mean diameter of the granular parts in the carbon fibrous structures was determined as 443 nm (SD 207 nm), that is 7.38 times larger than the outer diameter of the carbon fibers in the carbon fibrous structure. The mean roundness of the granular parts was 0.67 (SD 0.14).

Further, when the destruction test for carbon fibrous structure was performed according to the above mentioned procedure, the initial average fiber length ($D_{50}$) determined 30 minutes after the application of ultrasound was started was found to be 12.8 $\mu$m, while the mean length $D_{50}$ determined 500 minutes after the application of ultrasound was started was found to be 6.7 $\mu$m, which value was about half the initial value. This result showed that many breakages were given in the fine carbon fibers of the carbon fibrous structure. Whereas the variability (decreasing) rate for the diameter of granular part was only 4.8%, when the mean diameter ($D_{50}$) of the granular part determined 500 minutes after the application of ultrasound was started was compared with the initial average diameter ($D_{50}$) of the granular parts determined 30 minutes after the application of ultrasound was started. Considering measurement error, etc., it was found that the granular parts themselves were hardly destroyed even under the load condition that many breakages were given in the fine carbon fibers, and the granular parts still function as the binding site for the fibers mutually.

Table 2 provides a summary of the various physical properties as determined in Synthetic Example 1.
[Table 1]

| Particle (pieces) Distribution | Synthetic Example 1 |
|---|---|
| <50 $\mu$m | 49 |
| 50 $\mu$m to <60 $\mu$m | 41 |
| 60 $\mu$m to <70 $\mu$m | 34 |
| 70 $\mu$m to <80 $\mu$m | 32 |
| 80 $\mu$m to <90 $\mu$m | 16 |
| 90 $\mu$m to <100 $\mu$m | 12 |
| 100 $\mu$m to <110 $\mu$m | 7 |
| >110 $\mu$m | 16 |
| Area based circle-equivalent mean diameter | 72.8 $\mu$m |

[Table 2]

| | Synthetic Example 1 |
|---|---|
| Area based circle-equivalent mean diameter | 72.8 $\mu$m |
| Bulk density | 0.0032g/cm$^3$ |
| $I_D/I_G$ ratio | 0.090 |
| TG combustion temperature | 786 °C |
| Spacing for (002) faces | 3.383A |
| Particle's resistance at 0.5 g/cm$^3$ | 0.0173$\Omega$·cm |
| Particle's resistance at 0.8 g/cm$^3$ | 0.0096$\Omega$·cm |
| Particle's resistance at 0.9 g/cm$^3$ | 0.0083$\Omega$·cm |
| Density after decompression | 0.25g/cm$^3$ |

Synthetic Example 2

By the CVD process, carbon fibrous structures were synthesized using a part of the exhaust gas from the generation furnace as a recycling gas in order to use as the carbon source the carbon compounds such as methane, etc., included in the recycling gas, as well as a fresh toluene.

The synthesis was carried out in the presence of a mixture of ferrocene and thiophene as the catalyst, and under the reducing atmosphere of hydrogen gas. Toluene and the catalyst as a fresh raw material were heated to 380 °C along with the hydrogen gas in a preheat furnace, while a part of the exhaust gas taken out from the lower end of the generation furnace was used as a recycling gas. After it was adjusted to 380 °C, it was mixed with the fresh raw material gas on the way of the supplying line for the fresh raw material to the generation furnace. The mixed gas was then supplied to the generation furnace.

The composition ratio in the recycling gas used were found to be $CH_4$ 7.5%, $C_6H_6$ 0.3%, $C_2H_2$ 0.7%, $C_2H_6$ 0.1%, CO 0.3%, $N_2$ 3.5%, and $H_2$ 87.6% by the volume based molar ratio. The mixing flow rate was adjusted so that the mixing molar ratio of methane and benzene in the raw material gas to be supplied to the generation furnace, $CH_4/C_6H_6$ was set to 3.44 (wherein, it was considered that the toluene in the fresh raw material gas had been decomposed at 100% to $CH_4$:$C_6H_6$ = 1:1 by the heating in the preheat furnace.

In the final raw material gas, $C_2H_2$ , $C_2H_6$, and CO which were involved in the recycling gas to be mixed were naturally included. However, since these ingredients were very small amount, theymay substantiallybe ignored as the carbon source.

Then they were underwent thermal decomposition at 1250 °C in order to obtain the carbon fibrous structures (first intermediate) in an analogous fashion as Synthetic Example 1.

The constitution of the generation furnace used for the carbon fibrous structures (first intermediate) was the same as that shown in Fig.9, except that the cylindrical- shaped collisionmember 3 was omitted. The raw material gas supplying rate to the generation furnace was 1850 NL/min., and the pressure was 1.03 atms as in the case of Synthetic Example 1.

The synthesized first intermediate was baked at 900 °C in argon gas in order to remove hydrocarbons such as tar and to obtain a second intermediate. The R value of the second intermediate measured by the Raman spectroscopic analysis was found to be 0.83. Sample for electron microscopes was prepared by dispersing the first intermediate into toluene. SEM photo and TEM photo obtained for the sample are in much the same with those of Synthetic Example 1 shown in Figs. 1 and 2, respectively.

Further, the second intermediate underwent a high temperature heat treatment at 2600 °C in argon gas. The obtained aggregates of the carbon fibrous structures underwent pulverization using an air flow pulverizer in order to produce the carbon fibrous structures to be used in the present invention.

A sample for electron microscopes was prepared by dispersing ultrasonically the obtained carbon fibrous structures into toluene. SEM photo and TEM photos obtained for the sample are in much the same with those of Synthetic Example 1 shown in Fig. 3 and Figs.4A and 4B, respectively.

Separately, the obtained carbon fibrous structures were mounted on a sample holder for electron microscope, and observed for the particle distribution. The obtained results are shown in Table 3.

Further, X-ray diffraction analysis and Raman spectroscopic analysis were performed on the carbon fibrous structure before and after the high temperature heat treatment in order to examine changes in these analyses. The results are in much the same with those of Synthetic Example 1 shown in Figs. 6 and 7, respectively.

Additionally, it was found that the carbon fibrous structures had an area based circle-equivalent mean diameter of 75.8 $\mu$m, bulk density of 0.004 g/cm$^3$, Raman $I_D/I_G$ ratio of 0.086, TG combustion temperature of 807 °C, spacing of 3.386 A, particle's resistance of 0.0077 $\Omega$·cm, and density after decompression of 0.26 g/cm$^3$.

The mean diameter of the granular parts in the carbon fibrous structures was determined as 349.5 nm (SD 180.1 nm), that is 5.8 times larger than the outer diameter of the carbon fibers in the carbon fibrous structure. The mean roundness of the granular parts was 0.69 (SD 0.15).

Further, when the destruction test for carbon fibrous structure was performed according to the above mentioned procedure, the initial average fiber length ($D_{50}$) determined 30 minutes after the application of ultrasound was started was found to be 12.4 $\mu$m, while the mean length $D_{50}$ determined 500 minutes after the application of ultrasound was started was found to be 6.3 $\mu$m, which value was about half the initial value. This result showed that many breakages were given in the fine carbon fibers of the carbon fibrous structure. Whereas the variability (decreasing) rate for the diameter of granular part was only 4.2%, when the mean diameter ($D_{50}$) of the granular part determined 500 minutes after the application of ultrasound was started was compared with the initial average diameter ($D_{50}$) of the granular parts determined 30 minutes after the application of ultrasound was started. Considering measurement error, etc., it was found that the granular parts themselves were hardly destroyed even under the load condition that many breakages were given in the fine carbon, and the granular parts still function as the binding site for the fibers mutually.

Table 4 provides a summary of the various physical properties as determined in Example 2.

[Table 3]

| Particle (pieces)                Distribution | Synthetic Example 2 |
|---|---|
| <50 $\mu$m | 48 |
| 50 $\mu$m to <60 $\mu$m | 39 |
| 60 $\mu$m to <70 $\mu$m | 33 |
| 70 $\mu$m to <80 $\mu$m | 30 |
| 80 $\mu$m to <90 $\mu$m | 12 |
| 90 $\mu$m to <100 $\mu$m | 15 |
| 100 $\mu$m to <110 $\mu$m | 3 |
| >110 $\mu$m | 18 |
| Area based circle-equivalent mean diameter | 75.8 $\mu$m |

[Table 4]

|  | Synthetic Example 2 |
|---|---|
| Area based circle-equivalent mean diameter | 75.8 μm |
| Bulk density | 0.004g/cm$^3$ |
| $I_D/I_G$ ratio | 0.086 |
| TG combustion temperature | 807 °C |
| Spacing for (002) faces | 3.386 A |
| Particle's resistance at 0.5 g/cm$^3$ | 0.0161Ω·cm |
| Particle's resistance at 0.8 g/cm$^3$ | 0.0089Ω·cm |
| Particle's resistance at 0.9 g/cm$^3$ | 0.0077Ω·cm |
| Density after decompression | 0.26g/cm$^3$ |

Examples 1 - 4

2, 5, 10, or 25 % by weight of the carbon fibrous structures obtained by Referential Example 1 were added to polycarbonate resin (Panlite® L-1225LL, manufactured by TEIJIN Chemicals Ltd.). The obtained composite was then subjected to injection press molding using an injection press machine (MDIP-1400, manufactured by MEIKI Co. Ltd.) in order to obtain a molded plate of 4.8 mm in thickness. Sample plate was prepared by cutting a piece of 460 mm x 460mm in size from the molded plate.

The electromagnetic wave absorbing properties of the obtained samples were examined in accordance with the previously described method. As the results, with respect to all the samples in which the addition amount of the carbon fibrous structures were 2, 5, 10, and 25 % by weight, respectively, high electromagnetic wave absorbing property was demonstrated to the whole range of the examined frequencies of 1-20 GHz, particularly, to the frequencies of not less than 10 GHz, as shown in Table 5.

[Table 5]

| Example | Addition amount of carbon fibrous structures(%) | Electromagnetic wave absorbing property | |
|---|---|---|---|
|  |  | Frequency (GHz) | Attenuation (dB) |
| 1 | 2 | 2 | 9 |
|  |  | 8 | 12 |
|  |  | 10 | 8 |
|  |  | 15 | 12 |
|  |  | 20 | 23 |
| 2 | 5 | 2 | 14 |
|  |  | 8 | 24 |
|  |  | 10 | 32 |
|  |  | 15 | 36 |
|  |  | 20 | 38 |
| 3 | 10 | 2 | 19 |
|  |  | 8 | 38 |
|  |  | 10 | 38 |
|  |  | 15 | 45 |
|  |  | 20 | 53 |
| 4 | 25 | 2 | 21 |
|  |  | 8 | 39 |
|  |  | 10 | 39 |

(continued)

| Example | Addition amount of carbon fibrous structures(%) | Electromagnetic wave absorbing property | |
|---|---|---|---|
| | | Frequency (GHz) | Attenuation (dB) |
| | | 15 | 43 |
| | | 20 | 55 |

Examples 5 - 7

Epoxy type resin compositions in which the addition amount of the carbon fibrous structures were 0.05, 0.22, and 0.5 % by weight, respectively, were prepared by adding the carbon fibrous structures obtained in Synthetic Example 1 to an epoxy resin (ADEKA RESIN™ EP-4901E, manufactured by Asahi Denka Co., Ltd., a bisphenol A type epoxy resin, epoxy equivalent: 170), kneading them with a rotation - revolution type centrifugal mixer (Awatori-NERITARO AR-250, manufactured by Thinky Co., Ltd.) at a rotation speed of 800 rpm and a revolution speed of 2000 rpm for two minutes, then adding a hardener (ADEKA HARDENER™ EH-3895, manufactured by Asahi Denka Co., Ltd.) to the mixture, and further kneading them with the same mixer at a rotation speed of 60 rpm and a revolution speed of 2200 rpm for two minutes.

Each epoxy type resin composition thus obtained was poured into cells which each was composed of two glass plates, then resin composition poured was kept under a reduced pressure condition at 50 °C for 3 minutes in order to defoam the composition, and thereafter, it was left standing at 30 °C for a night, and further at 80 °C for 3 hours in order to harden the resin composition. Thereby, sample plates of 200 mm x 200mm x 3.9 mm (only for the composition which includes carbon fibrous structures of 0.5 % by weight, the thickness was set to 4.5 mm) were obtained.

The electromagnetic wave absorbing properties of the obtained sample plates were examined in accordance with the previously described method. Incidentally, above mentioned sample plates were combined at four pieces per unit without leaving space between them in order to make the size of 400 mm x 400 mm, and then they were assembled to the open flame portion. As the results, with respect to all the samples in which the addition amount of the carbon fibrous structures were 0.05, 0.22, and 0.5 % by weight, respectively, electromagnetic wave absorbing property was demonstrated to the whole range of the examined frequencies of 1 - 20 GHz, as shown in Table 6.

[Table 6]

| Example | Addition amount of carbon fibrous structures(%) | Electromagnetic wave absorbing property | |
|---|---|---|---|
| | | Frequency (GHz) | Attenuation (dB) |
| 5 | 0.05 | 2 | 3 |
| | | 5 | 10 |
| | | 10 | 5 |
| | | 15 | 4 |
| | | 19 | 7 |
| 6 | 0.22 | 2 | 5 |
| | | 5 | 14 |
| | | 10 | 8 |
| | | 15 | 8 |
| | | 19 | 12 |
| 7 | 0.5 | 2 | 8 |
| | | 5 | 18 |
| | | 10 | 14 |
| | | 15 | 18 |
| | | 19 | 22 |

## Claims

1. Electromagnetic wave absorber which includes carbon fibrous structures, at a rate of 0.01 - 25 % by weight based on the total weight, in a matrix, wherein the carbon fibrous structure comprises a three dimensional network of carbon fibers each having an outside diameter of 15 - 100 nm, wherein the carbon fibrous structure further comprises a granular part with which the carbon fibers are tied together in the state that the concerned carbon fibers are externally elongated therefrom, and wherein the granular part is produced in a growth process of the carbon fibers.

2. The electromagnetic wave absorber according to Claim 1, wherein the carbon fibrous structures have $I_D/I_G$ ratio determined by Raman spectroscopy of not more than 0.2.

3. The electromagnetic wave absorber according to Claim 1 or 2, wherein the matrix comprises an organic polymer.

4. The electromagnetic wave absorber according to Claim 1 or 2, wherein the matrix comprises an inorganic material.

5. The electromagnetic wave absorber according to one of Claims 1-4, wherein a filling agent selected from the group consisting of metallic particles, silica, calcium carbonate, magnesium carbonate, carbon blacks, carbon fibers, glass fibers, and blends of two or more of these materials is further added therein.

FIG.1

FIG.2

FIG. 3

FIG. 4A

FIG. 4B

FIG. 5

CNRI      LEI   7.0kV   X100   100μm   WD 14.9mm

## FIG. 6

## FIG. 7

FIG. 8

<table>
<tr><td colspan="2" align="center">**INTERNATIONAL SEARCH REPORT**</td><td colspan="2">International application No.<br>PCT/JP2006/320733</td></tr>
</table>

A.  CLASSIFICATION OF SUBJECT MATTER
*H05K9/00*(2006.01)i, *C01B31/02*(2006.01)i, *D01F9/127*(2006.01)i, *H01Q17/00*
(2006.01)i

According to International Patent Classification (IPC) or to both national classification and IPC

B.  FIELDS SEARCHED

Minimum documentation searched (classification system followed by classification symbols)
H05K9/00, C01B31/02, D01F9/127, H01Q17/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2004-250280 A  (Futaba Corp.),<br>09 September, 2004 (09.09.04),<br>Par. Nos. [0016] to [0024], [0060] to [0071];<br>Figs. 8 to 12<br>& US 2004/0160157 A1 | 1<br>2-5 |
| X<br>Y | JP 2002-266170 A  (Showa Denko Kabushiki<br>Kaisha),<br>18 September, 2002 (18.09.02),<br>Par. Nos. [0016] to [0023]; Figs. 1 to 3<br>& US 2004/0036060 A1    & WO 02/49412 A1<br>& AU 1950702 A          & CA 2431727 A<br>& CN 1481454 A | 1<br>2-5 |

| ☒  Further documents are listed in the continuation of Box C. | ☐  See patent family annex. |
|---|---|

| | |
|---|---|
| *    Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>09 January, 2007 (09.01.07) | Date of mailing of the international search report<br>16 January, 2007 (16.01.07) |
|---|---|
| Name and mailing address of the ISA/<br>Japanese Patent Office | Authorized officer |
| Facsimile No. | Telephone No. |

Form PCT/ISA/210 (second sheet) (April 2005)

## INTERNATIONAL SEARCH REPORT

| | International application No. |
|---|---|
| | PCT/JP2006/320733 |

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2005/095687 A1  (Bussan Nanotech Reserach Institute Inc.), 13 October, 2005 (13.10.05), Claim 1 & JP 2006-111515 A       & US 2006/0062715 A1 | 2-5 |
| Y | JP 2005-150461 A  (Yukadenshi Co., Ltd.), 09 June, 2005 (09.06.05), Par. Nos. [0051], [0052] (Family: none) | 5 |
| A | JP 11-177275 A  (Kitakawa Kogyo Kabushiki Kaisha), 02 July, 1999 (02.07.99), Full text; Figs. 1, 2 (Family: none) | 1-5 |
| A | JP 2004-176244 A  (Showa Denko Kabushiki Kaisha), 24 June, 2004 (24.06.04), Full text; Figs. 1 to 4 & US 2006/0046051 A1    & WO 2004/044289 A1 | 1-5 |
| A | JP 2003-227039 A  (Showa Denko Kabushiki Kaisha), 15 August, 2003 (15.08.03), Full text; Figs. 1 to 3 & US 2004/0258606 A1    & WO 03/040445 A1 | 1-5 |
| A | JP 2004-143652 A  (Showa Denko Kabushiki Kaisha), 20 May, 2004 (20.05.04), Full text; Figs. 1 to 10 & US 2004/0041130 A1 | 1-5 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005011878 A
- JP 2003124011 A
- JP 2003158395 A
- JP 2005063994 A
- JP 2004327727 A

### Non-patent literature cited in the description

- Latest Experimental Technique For Carbon Materials (Analysis Part. 2001